# EUROPÄISCHE PATENTSCHRIFT

(11) **EP 0 477 594 B1**
(45) Veröffentlichungstag und Bekanntmachung des Hinweises auf die Patenterteilung: **17.01.1996**
(21) Anmeldenummer: 91114768.4
(22) Anmeldetag: 02.09.1991
(51) Int. Cl.: H01L 29/74

(54) **Abschaltbarer Thyristor**
Turn-off thyristor
Thyristor à passage à l'ouverture

(30) Priorität: 25.09.1990 DE 4030299
(43) Veröffentlichungstag der Anmeldung: 01.04.1992
(73) Patentinhaber: SIEMENS AKTIENGESELLSCHAFT, D-80333 München (DE)
(72) Erfinder: Oppermann, Klaus-Günter, W-8150 Holzkirchen (DE); Gerstenmaier, York, Dr., W-8000 München 19 (DE); Stoisiek, Michael, Dr., W-8012 Ottobrunn (DE)

(56) Entgegenhaltungen:
- EP-A- 0 329 992
- EP-A- 0 389 862

## Beschreibung

Die Erfindung bezieht sich auf einen abschaltbaren Thyristor nach den gleichlautenden Oberbegriffen der Patentansprüche 1 und 2.

In der älteren europäischen Patentanmeldung Nr. 90 104 736.5 wird ein Thyristor dieser Art beschrieben, bei dem jedes Emittergebiet über ein individuell zugeordnetes Widerstandselement mit dem ersten Hauptanschluß verbunden ist und bei dem das Widerstandselement insbesondere als eine Belegung aus widerstandsbehaftetem Material ausgebildet ist, die auf einer die erste Hauptfläche bedeckenden, elektrisch isolierenden Schicht aufgebracht ist. Derartige Widerstandselemente führen jedoch zu einer unerwünschten Erhöhung der im Durchlaßzustand des Thyristors an diesem abfallenden Spannung. Der Inhalt dieser älterer europ Patentanmeldung gilt daher gemäß Art 54 (3) EPÜ als Stand der Technik. Ein ahnlicher Thyristor ist in dem Dokument EP-A-329992 beschrieben.

Der Erfindung liegt die Aufgabe zugrunde, einen Thyristor der eingangs genannten Art anzugeben, bei dem eine thermische Zerstörung beim Abschalten sicher vermieden wird, ohne daß die verwendeten Widerstandselemente zu einer Erhöhung der im Durch-laßzustand des Thyristors an diesem abfallenden Spannung führen. Das wird erfindungsgemäß durch die Patentansprüche 1 oder 5 erreicht.

Der mit der Erfindung erzielbare Vorteil liegt insbesondere darin, daß die in die Emitterstrukturen des Thyristors integrierten, als schaltbare Feldeffekttransistoren ausgebildeten Widerstandselemente im Durchlaßzustand des Thyristors nur einen sehr geringen Spannungsabfall verursachen, während sie beim Abschalten des Thyristors die Verbindung von den Emittergebieten zum ersten Hauptanschluß jeweils vollständig unterbrechen.

Die Ansprüche 2 bis 5 sind auf bevorzugte Ausgestaltungen und Weiterbildungen der Erfindung gerichtet.

Die Erfindung wird nachfolgend anhand von in der Zeichnung dargestellten, bevorzugten Ausführungsbeispielen näher erläutert. Dabei zeigt:
- Figur 1: ein erstes Ausführungsbeispiel mit in den Halbleiterkörper des Thyristors integrierten Widerstandselementen und
- Figur 2: ein zweites Ausführungsbeispiel mit in Dünnfilmtechnik realisierten Widerstandselementen.

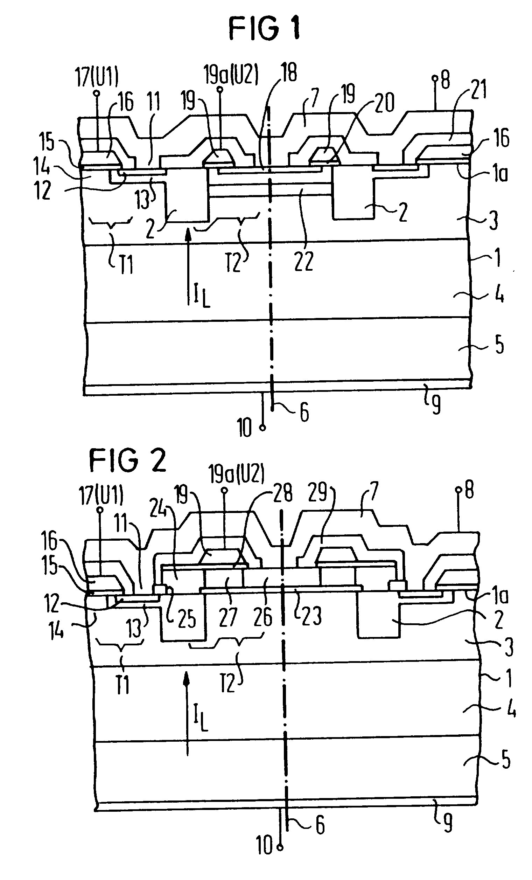

In Figur 1 ist ein Teil eines abschaltbaren Thyristors mit einem aus dotiertem Halbleitermaterial, zum Beispiel Silizium, bestehenden Halbleiterkörper 1 schematisch im Schnitt dargestellt. Der dargestellte Teil enthält ein n-leitendes Emittergebiet 2, das in eine p-leitende Schicht 3 eingefügt ist, die die p-Basis bildet. Eine darunterliegende, n-leitende Schicht stellt die n-Basis 4 dar, während die unterste, p-leitende Schicht den p-Emitter 5 des Thyristors bildet. Das Emittergebiet 2, das von der oberen Hauptfläche 1a des Thyristors ausgeht, weist zum Beispiel eine zu einer vertikalen Achse 6 symmetrische, in sich geschlossene, etwa hohlzylindrische Form auf. Eine andere Form dieses Gebiets könnte zum Beispiel die eines in lateraler Richtung orientierten, rechteckförmigen bzw. quadratischen Rahmens sein. In beiden Fällen wäre ein weiterer Querschnitt, der durch die Achse 6 senkrecht zur Bildebene von Figur 1 gelegt wird, deckungsgleich mit dem bisher beschriebenen Querschnitt von Figur 1. Der schaltbare Thyristor setzt sich aus vielen entsprechend Figur 1 ausgebildeten Teilen zusammen, die neben- und hintereinander angeordnet sind. Dabei sind die Schichten 3 bis 5 als über den ganzen Thy-ristorquerschnitt verlaufende Schichten ausgebildet, während das Emittergebiet 2 zusammen mit den entsprechenden Emittergebieten der übrigen Teile die oberste, n-leitende Schicht des Thyristors und damit den n-Emitter desselben bildet.

Das n-Emittergebiet 2 ist über ein noch später zu beschreibendes Widerstandselement mit einer leitenden Belegung 7 verbunden, die an einen kathodenseitigen Hauptanschluß 8 geschaltet ist. Der p-Emitter 5 ist mit einer anodenseitigen Elektrode 9 versehen, die mit einem zweiten, anodenseitigen Hauptanschluß 10 verbunden ist. Dabei verbindet die leitende Belegung 7 die n-Emittergebiete aller Thyristorteile mit dem ersten Hauptanschluß 8, während die anodenseitige Elektrode 9 allen Thyristorteilen gemeinsam ist.

Neben jedem n-Emittergebiet 2 ist eine diesem zugeordnete Elektrode 11 vorgesehen, die aus einem Teil der leitenden Belegung 7 besteht und somit ebenfalls mit dem Hauptanschluß 8 leitend verbunden ist. Die Elektrode 11 kontaktiert eine p-leitende Halbleiterzone 12, die in einen seitlichen Ansatz 13 des n-Emittergebiets 2 eingefügt ist. Zusammen mit dem an den Ansatz 13 angrenzenden Teil 14 der p-Basis 2 und dem zwischen 12 und 14 liegenden, randseitigen Teil des seitlichen Ansatzes 13, der von einer durch eine dünne, elektrisch isolierende Schicht 15 von der Hauptfläche la getrennten Gateelektrode 16 überdeckt wird, bildet die Zone 12 einen ersten Feldeffekttransistor T1, der die p-Basis 3 mit der leitenden Belegung 7 und weiter mit dem Hauptanschluß 8 verbindet. Diese Verbindung stellt einen Abschaltstrompfad für den dargestellten Thyristorteil dar. Die Gateelektrode 16 ist mit den entsprechenden Gate-elektroden der übrigen Thyristorteile an einen gemeinsamen Gateanschluß 17 geführt.

Das Widerstandselement, das das n-Emittergebiet 2 mit der leitenden Belegung 7 verbindet, besteht aus einem zweiten Feldeffekttransistor T2. Dieser umfaßt einen randseitigen Teil des n-Emittergebiets 2, ein in die p-Basis 3 eingefügtes, n-leitendes Halbleitergebiet 18 und einen zwischen 2 und 18 liegenden, an die Hauptfläche la angrenzenden Teil der p-Basis 3, der von einer Gateelektrode 19 überdeckt wird. Diese ist durch eine dünne, elektrisch isolierende Schicht 20 von der Hauptfläche la getrennt. Die Gateelektrode 19 weist einen Anschluß 19a auf. Mit 21 ist eine die Teile 16 und 19 von der leitenden Belegung 7 trennende Zwischenisolationsschicht, zum Beispiel aus SiO₂, bezeichnet.

Befindet sich der Thyristor im stromführenden Zustand, so fließt ein auf den dargestellten Thyristorteil entfallender Teil I_{L} des Laststroms vom Hauptanschluss 10 über die Elektrode 9 zum n-Emittergebiet 2 und von diesem über den Transistor T2, der mittels einer dem Anschluß 19a zugeführten positiven Spannung U2 leitend geschaltet ist, zur Belegung 7 und über diese zum Hauptanschluß 8. Dabei ist T1 durch Zuführung einer positiven Spannung U1 an den Anschluß 17 gesperrt.

Beim Abschalten des Thyristors wird nun T1 durch Zuführen einer negativen Spannung U1 an den Anschluß 17 leitend geschaltet, während T2 durch Zuführen einer negativen Spannung U2 an den Anschluß 19a gesperrt wird. Damit wird der Laststromanteil I_{L} nicht mehr dem n-Emittergebiet 2 zugeführt, sondern über den wirksam geschalteten Abschaltstrompfad 3, 14, 12 und 11 der Belegung 7 und damit dem Hauptanschluß 8, so daß der Thyristor gelöscht wird. An dem gesperrten Transistor T2 fällt hierbei eine beträchtliche Spannung ab, die über die leitende Belegung 7 auch der Halbleiterzone 12 zugeführt wird, so daß das Umlenken des eingezeichneten Laststromanteils I_{L} auf den Abschaltstrompfad sicher bewerkstelligt wird. Hierdurch wird ein sicheres, zerstörungsfreies Abschalten des Thyristors erreicht, und zwar auch dann, wenn der Laststromanteil I_{L} in einzelnen Thyristorteilen durch eine Stromfilamentierung größer sein sollte als in anderen. Die Anordnung der Transistoren T2 in den einzelnen Thyristorteilen sorgt für eine Abschaltung auch von solchen Laststromteilen, die wesentlich größer sind als andere.

Nach einer vorteilhaften Weiterbildung des vorstehend beschriebenen Ausführungsbeispiels der Erfindung wird unterhalb des n-leitenden Halbleiters 18 eine Isolierschicht 22 in die p-Basis 3 eingefügt, um den Abschaltstrompfad 3, 14, 12, 11, 8 deutlich gegenüber dem Laststrompfad im stromführenden Betriebszustand des Thyristors zu unterscheiden. Die Isolierschicht 22 kann durch eine Tiefimplantation von 0₂-Ionen in den Halbleiterkörper 1 erzeugt werden. Eine mögliche Alternative hierzu besteht darin, die Schicht 22 nicht als Isolierschicht, sondern als Schicht mit stark reduzierter Träger-lebensdauer auszubilden. Dies wird vorzugsweise durch eine Tiefimplantation von Ionen eines Stoffes wie zum Beispiel Argon, Helium oder Stickstoff erreicht, der das Kristallgitter des Halbleiterkörpers innerhalb der Schicht 22 zerstört. Als eine weitere Alternative kann die Schicht 22 auch als eine hochdotierte p-Zone ausgebildet werden, was durch eine Tiefimplantation von dem zur Dotierung der p-Basis 3 verwendeten Dotierstoff, zum Beispiel Bor, durchgeführt werden kann.

Das in Figur 2 dargestellte Ausführungsbeispiel der Erfindung hat innerhalb des HalbleiterKörpers 1 denselben Aufbau wie das Ausführungsbeispiel nach Figur 1. Lediglich das Halbleitergebiet 18 entfällt. Zum Unterschied von Figur 1 wird der das Widerstandselement darstellende Feldeffekttransistor T2 hier in Dünnfilmtechnik realisiert. Im einzelnen wird hierbei eine dünne, elektrisch isolierende Schicht 23 im Bereich des n-Emittergebiets 2 auf der Hauptfläche 1a aufgebracht. Auf der Schicht 23 wird dann eine Schicht aus dotiertem Halbleitermaterial epitaktisch aufgewachsen, die ein erstes, n⁺-dotiertes Anschlußgebiet 24, ein zweites, n⁺-dotiertes Anschlußgebiet 26 und ein dazwischenliegendes p-dotiertes Kanalgebiet 27 aufweist. Das Anschlußgebiet 24 kontaktiert das n-Emittergebiet 2 in einem Kontaktloch 25 der isolierenden Schicht 23. Das Kanalgebiet 27 wird von einer isolierenden Schicht 28 abgedeckt, auf der dann die Gateelektrode 19 von T2 aufgebracht ist. Mit 29 ist eine Zwischenisolationsschicht bezeichnet, die die Gateelektroden 16 und 19 von der leitenden Belegung 7 elektrisch isoliert. Die Arbeitsweise des Ausführungsbeispiels nach Figur 2 entspricht der des Ausführungsbeispiels nach Figur 1.

Weitere Ausführungsformen der Erfindung ergeben sich dadurch, daß sämtliche Halbleitergebiete bzw. -schichten durch solche des entgegengesetzten Leitungstyps ersetzt werden, wobei die zugeführten Spannungen durch solche des entgegengesetzten Vorzeichens zu ersetzen sind.

## Patentansprüche

1. Abschaltbarer Thyristor mit vier aufeinanderfolgenden Halbleiterschichten unterschiedlichen Leitungstyps, die jeweils einen Emitter eines ersten Leitungstyps, eine Basis (3) eines zweiten Leitungstyps, eine Basis (4) des ersten Leitungstyps und einen Emitter (5) des zweiten Leitungstyps bilden, bei dem der Emitter des ersten Leitungstyps in eine Vielzahl von Emittergebieten (2) aufgeteilt ist, die jeweils über individuell zugeordnete Widerstandselemente mit einem ersten Hauptanschluß (8) verbunden sind, bei dem der Emitter (5) des zweiten Leitungstyps mit einem zweiten Hauptanschluß (10) verbunden ist, bei dem in einer ersten Hauptfläche (1a) neben jedem Emittergebiet (2) eine diesem zugeordnete Elektrode (11) vorgesehen ist, über die jeweils ein Abschaltstrompfad von der Basis (3) des zweiten Leitungstyps zum ersten Hauptanschluß (8) hin verläuft, wobei
jeder Abschaltstrompfad einen ersten Feldeffekttransistor (T1) aufweist, der ihn beim Abschalten des Thyristors wirksam schaltet,
der erste Feldeffekttransistor (T1) aus einer in einen seitlichen Ansatz (13) eine Emittergebietes (2) eingefügten Halbleiterzone (12) des zweiten Leitungstyps, aus einem neben diesem Ansatz (13) liegenden Teil (14) der Basis (3) des zweiten Leitungstyps und aus dem dazwischenliegenden randseitigen Teil des seitlichen Ansatzes (13) besteht, der von einer gegen die erste Hauptfläche (1a) isoliert angeordneten, dritten Gateelektrode (16) überdeckt ist,
die ersten Feldeffekttransistoren (T1) aller Abschaltstrompfade einen gemeinsamen Gateanschluß (17) aufweisen,
jedes Widerstandselement aus einem zweiten Feldeffekttransistor (T2) besteht, der das zugeordnete Emittergebiet (2), ein im Abstand neben diesem in die Basis (3) des zweiten Leitungstyps eingefügtes Halbleitergebiet (18) des ersten Leitungstyps und einen zwischen diesen Gebieten liegenden Teilbereich der Basis (3) des zweiten Leitungstyps umfaßt,
wobei dieser Teilbereich von einer ersten, gegenüber der ersten Hauptfläche (1a) isoliert angeordneten Gateelektrode (19) überdeckt und durch eine Zone (22) vom Rest der Basis (3) des zweiten Leitungstyps derart getrennt ist, daß ein direkter Stromfluß zwischen diesem Teilbereich und dem Rest der Basis zumindest weitgehend verhindert ist.

2. Abschaltbarer Thyristor nach Anspruch 1,
**dadurch gekennzeichnet**,
daß unterhalb des Halbleitergebiets (18) des ersten Leitungstyps in die Basis (3) des zweiten Leitungstyps eine Isolierschicht (22) eingefügt ist.

3. Abschaltbarer Thyristor nach Anspruch 1,
**dadurch gekennzeichnet**,
daß unterhalb des Halbleitergebiets (18) des ersten Leitungstyps in die Basis (3) des zweiten Leitungstyps eine Zone (22) mit stark reduzierter Trägerlebensdauer eingefügt ist.

4. Abschaltbarer Thyristor nach Anspruch 1,
**dadurch gekennzeichnet**,
daß die Basis (3) des zweiten Leitungstyps unterhalb des Halbleitergebiets (18) des ersten Leitungstyps eine Zone (22) mit erhöhter Dotierungskonzentration aufweist.

5. Abschaltbarer Thyristor mit vier aufeinanderfolgenden Halbleiterschichten unterschiedlichen Leitungstyps, die jeweils einen Emitter eines ersten Leitungstyps, eine Basis (3) eines zweiten Leitungstyps, eine Basis (4) des ersten Leitungstyps und einen Emitter (5) des zweiten Leitungstyps bilden, bei dem der Emitter des ersten Leitungstyps in eine Vielzahl von Emittergebieten (2) aufgeteilt ist, die jeweils über individuell zugeordnete Widerstandselemente mit einem ersten Hauptanschluß (8) verbunden sind, bei dem der Emitter (5) des zweiten Leitungstyps mit einem zweiten Hauptanschluß (10) verbunden ist, bei dem in einer ersten Hauptfläche (1a) neben jedem Emittergebiet (2) eine diesem zugeordnete Elektrode (11) vorgesehen ist, über die jeweils ein Abschaltstrompfad von der Basis (3) des zweiten Leitungstyps zum ersten Hauptanschluß (8) hin verläuft, wobei
jeder Abschaltstrompfad einen ersten Feldeffekttransistor (T1) aufweist, der ihn beim Abschalten des Thyristors wirksam schaltet,
der erste Feldeffekttransistor (T1) aus einer in einen seitlichen Ansatz (13) eines Emittergebiets (2) eingefügten Halbleiterzone (12) des zweiten Leitungstyps, aus einem neben diesem Ansatz (13) liegenden Teil (14) der Basis (3) des zweiten Leitungstyps und aus dem dazwischenliegenden randseitigen Teil des seitlichen Ansatzes (13) besteht, der von einer gegen die erste Hauptfläche (1a) isoliert angeordneten, dritten Gateelektrode (16) überdeckt ist,
die ersten Feldeffekttransistoren (T1) aller Abschaltstrompfade einen gemeinsamen Gateanschluß (17) aufweisen und daß jedes Widerstandselement aus einem in Dünnfilmtechnik realisierten, durch eine elektrisch isolierende Schicht (23) von der ersten Hauptfläche (1a) getrennten, zweiten Feldeffekttransistor (T2) besteht, der ein erstes Anschlußgebiet (24) des ersten Leitungstyps, ein zweites Anschlußgebiet (26) des gleichen Leitungstyps und ein zwischen den Anschlußgebieten liegendes Kanalgebiet (27) des zweiten Leitungstyps umfaßt, wobei das erste Anschlußgebiet (24) das zugeordnete Emittergebiet (2) in einem Kontaktloch (25) kontaktiert, das zweite Anschlußgebiet (26) mit dem ersten Hauptanschluß (8) verbunden ist und das Kanalgebiet (27) von einer zweiten, ihm gegenüber isoliert angeordneten Gateelektrode (19) überdeckt wird.

## Claims

1. Gate turn-off thyristor having four successive semiconductor layers of different conduction type, which respectively form an emitter of a first conduction type, a base (3) of a second conduction type, a base (4) of the first conduction type and an emitter (5) of the second conduction type, in which the emitter of the first conduction type is divided into a multiplicity of emitter regions (2) which are respectively connected to a first main connection (8) via individually assigned resistance elements, in which the emitter (5) of the second conduction type is connected to a second main connection (10), in which there is provided in a first main area (1a), in addition to each emitter region (2), an electrode (11) which is assigned to the latter and via which a gate turn-off current path runs in each case from the base (3) of the second conduction type towards the first main connection (8),
each gate turn-off current path having a first field-effect transistor (T1) which activates the said path when the thyristor is turned off,
the first field-effect thyristor (T1) comprising a semiconductor region (12) of the second conduction type which is inserted into a lateral shoulder (13) of an emitter region (2), a portion (14), situated next to this shoulder (13), of the base (3) of the second conduction type, and the edge portion, situated therebetween, of the lateral shoulder (13) which is covered by a third gate electrode (16) arranged in a manner insulated from the first main area (1a),
the first field-effect transistors (T1) of all the gate turn-off current paths having a common gate connection (17),
each resistance element comprising a second field-effect transistor (T2) which includes the assigned emitter region (2), a semiconductor region (18) of the first conduction type which is inserted, at a distance from and next to the said emitter region, into the base (3) of the second conduction type, and a subregion, situated between these regions, of the base (3) of the second conduction type,
this subregion being covered by a first gate electrode (19) arranged in a manner insulated from the first main area (1a), and being isolated by a region (22) from the rest of the base (3) of the second conduction type in such a manner that a direct current flow between this subregion and the rest of the base is prevented at least to a large extent.

2. Gate turn-off thyristor according to Claim 1, characterized
in that an insulating layer (22) is inserted into the base (3) of the second conduction type underneath the semiconductor region (18) of the first conduction type.

3. Gate turn-off thyristor according to Claim 1, characterized
in that a region (22) having a greatly reduced carrier life is inserted into the base (3) of the second conduction type underneath the semiconductor region (18) of the first conduction type.

4. Gate turn-off thyristor according to Claim 1, characterized
in that the base (3) of the second conduction type has a region (22) of increased doping concentration underneath the semiconductor region (18) of the first conduction type.

5. Gate turn-off thyristor having four successive semiconductor layers of different conduction type, which respectively form an emitter of a first conduction type, a base (3) of a second conduction type, abase (4) of the first conduction type and an emitter (5) of the second conduction type, in which the emitter of the first conduction type is divided into a multiplicity of emitter regions (2) which are respectively connected to a first main connection (8) via individually assigned resistance elements, in which the emitter (5) of the second conduction type is connected to a second main connection (10), in which there is provided in a first main area (1a), in addition to each emitter region (2), an electrode (11) which is assigned to the latter and via which a gate turn-off current path runs in each case from the base (3) of the second conduction type towards the first main connection (8),
each gate turn-off current path having a first field-effect transistor (T1) which activates the said path when the thyristor is turned off,
the first field-effect thyristor (T1) comprising a semiconductor region (12) of the second conduction type which is inserted into a lateral shoulder (13) of an emitter region (2), a portion (14), situated next to this shoulder (13), of the base (3) of the second conduction type, and the edge portion, situated therebetween, of the lateral shoulder (13) which is covered by a third gate electrode (16) arranged in a manner insulated from the first main area (1a),
the first field-effect transistors (T1) of all the gate turn-off current paths having a common gate connection (17), and
each resistance element comprising a second field-effect transistor (T2) which is implemented using thin-film technology, is isolated from the first main area (1a) by an electrically insulating layer (23) and includes a first connection region (24) of the first conduction type, a second connection region (26) of the same conduction type and a channel region (27) of the second conduction type situated between the connection regions, the first connection region (24) making contact with the assigned emitter region (2) in a contact hole (25), the second connection region (26) being connected to the first main connection (8), and the channel region (27) being covered by a second gate electrode (19) arranged in a manner insulated therefrom.

## Revendications

1. Thyristor à passage à l'ouverture comportant quatre couches semiconductrices successives de différente nature de conductivité, qui forment à chaque fois un émetteur d'une première nature de conductivité, une base (3) d'une deuxième nature de conductivité, une base (4) de la première nature de conductivité et un émetteur (5) de la deuxième nature de conductivité, dans lequel l'émetteur de la première nature de conductivité est partagé en une multiplicité de régions d'émetteur (2) qui sont à chaque fois raccordées à une première borne principale (8) par l'intermédiaire d'éléments de résistance affectés individuellement, dans lequel l'émetteur (5) de la deuxième nature de conductivité est raccordé à une deuxième borne principale (10), dans lequel dans une première surface principale (1a), prés de chaque région d'émetteur (2), est prévue une électrode (11) affectée à celle-ci, par l'intermédiaire de laquelle, à chaque fois, un trajet du courant de rupture passe de la base (3) de la deuxième nature de conductivité vers la première borne principale (8), chaque trajet du courant de rupture présentant un premier transistor à effet de champ (T1) qui le commute efficacement lors de la déconnexion du thyristor, le premier transistor à effet de champ (T1) se composant d'une zone semi-conductrice (12) de la deuxième nature de conductivité insérée dans un épaulement latéral (13) d'une région d'émetteur (2), d'une partie (14), située près de cet épaulement (13), de la base (3) de la deuxième nature de conductivité et de la partie marginale de l'épaulement latéral (13) située entre les deux, qui est recouverte par une troisième électrode de grille (16) disposée de façon isolée contre la première surface principale (1a), les premiers transistors à effet de champ (T1) de tous les trajets du courant de rupture présentant une borne de grille (17) commune, chaque élément de résistance se composant d'un deuxième transistor à effet de champ (T2), qui comprend la région d'émetteur (2) affectée,une région semi-conductrice (18) de la première nature de conductivité insérée à distance à côté de celle-ci dans la base (3) de la deuxième nature de conductivité et une zone partielle de la base (3) de la deuxième nature de conductivité située entre ces régions, cette zone partielle étant recouverte par une première électrode de grille (19) disposée de façon isolée en face de la première surface principale (1a) et étant de la sorte séparée par une zone (22) du reste de la base (3) de la deuxième nature de conductivité, une conduction de courant directe étant au moins largement empêchée entre cette zone partielle et le reste de la base.

2. Thyristor à passage à l'ouverture selon la revendication 1, caractérisé en ce que en dessous de la région semi-conductrice (18) de la première nature de conductivité une couche isolante (22) est insérée dans la base (3) de la deuxième nature de conductivité.

3. Thyristor à passage à l'ouverture selon la revendication 1, caractérisé en ce que en dessous de la région semi-conductrice (18) de la première nature de conductivité une zone (22) ayant une durée de vie du support fortement réduite est insérée dans la base (3) de la deuxième nature de conductivité.

4. Thyristor à passage à l'ouverture selon la revendication 1, caractérisé en ce que la base (3) de la deuxième nature de conductivité présente en dessous de la région semi-conductrice (18) de la première nature de conductivité une zone (22) ayant une concentration de dopage élevée.

5. Thyristor à passage à l'ouverture comportant quatre couches semiconductrices successives de différente nature de conductivité, qui forment à chaque fois un émetteur d'une première nature de conductivité, une base (3) d'une deuxième nature de conductivité, une base (4) de la première nature de conductivité et un émetteur (5) de la deuxième nature de conductivité, dans lequel l'émetteur de la première nature de conductivité est partagé en une multiplicité de régions d'émetteur (2), qui sont à chaque fois raccordées à une première borne principale (8) par l'intermédiaire d'éléments de résistance affectés individuellement, dans lequel l'émetteur (5) de la deuxième nature de conductivité est raccordé à une deuxième borne principale (10), dans lequel dans une première surface principale (1a), prés de chaque région d'émetteur (2), est prévue une électrode (11) affectée à celle-ci, par l'intermédiaire de laquelle, à chaque fois, un trajet du courant de rupture passe de la base (3) de la deuxième nature de conductivité vers la première borne principale (8), chaque trajet du courant de rupture présentant un premier transistor à effet de champ (T1), qui le commute efficacement lors de la déconnexion du thyristor, le premier transistor à effet de champ (T1) se composant d'une zone semi-conductrice (12) de la deuxième nature de conductivité insérée dans un épaulement latéral (13) d'une région d'émetteur (2), d'une partie (14), située à côté de cet épaulement (13), de la base (3) de la deuxième nature de conductivité et de la partie marginale de l'épaulement latéral (13) située entre les deux, qui est recouverte par une troisième électrode de grille (16) disposée de façon isolée contre la première surface principale (1a), les premiers transistors à effet de champ (T1) de tous les trajets du courant de rupture présentant une borne de grille commune (17) et chaque élément de résistance se composant d'un deuxième transistor à effet de champ (T2) réalisé selon la technique des couches minces, séparé de la première surface principale (la) par une couche isolante (23) électriquement, qui entoure une première région de borne (24) de la première nature de conductivité, une deuxième région de borne (26) de la même nature de conductivité et une région de canal (27) de la deuxième nature de conductivité située entre les régions de borne, la première région de borne (24) mettant en contact, dans une perforation de contact (25), la région d'émetteur (2) affectée, la deuxième région de borne (26) étant raccordée à la première borne principale (8) et la région de canal (27) étant recouverte d'une deuxième électrode de grille, disposée de façon isolée en face d'elle.
